Europäisches Patentamt

European Patent Office

Office européen des brevets

(11) Veröffentlichungsnummer: **0 511 474 A1**

# EUROPÄISCHE PATENTANMELDUNG

(21) Anmeldenummer: **92103856.8**

(22) Anmeldetag: **06.03.92**

(51) Int. Cl.5: **H02K 5/22**, H01R 23/66

(30) Priorität: **15.03.91 DE 4108427**

(43) Veröffentlichungstag der Anmeldung:
**04.11.92 Patentblatt 92/45**

(84) Benannte Vertragsstaaten:
**AT BE CH DE DK ES FR GB GR IT LI NL PT SE**

(71) Anmelder: **WILO GmbH**
**Nortkirchenstrasse 100**
**W-4600 Dortmund 30(DE)**

(72) Erfinder: **Lütkenhaus, Norbert**
**Rönhabenweg 33**
**W-4716 Olfen(DE)**
Erfinder: **Kech, Hansjürgen**
**Hermann-Oberth-Strasse 6**
**W-5804 Herdecke(DE)**
Erfinder: **Tolksdorf, Frank**
**Jungfernbruch 26**
**W-5800 Hagen 7(DE)**

(74) Vertreter: **Patentanwaltsbüro Cohausz &**
**Florack**
**Schumannstrasse 97**
**W-4000 Düsseldorf 1(DE)**

(54) **Elektrische Verbindung für einen Elektromotor.**

(57) Es handelt sich um eine Elektrische Verbindung zwischen einem Elektromotor und einem Anschlußteil wie einem Anschlußkasten (2) oder einer Stekkeraufnahme (6), wobei sie eine Leiterfolie (8) mit mehreren zueinander parallelen Leiterbahnen aufweist.

Fig.2

Die Erfindung betrifft eine elektrische Verbindung zwischen einem Elektromotor und einem Anschlußteil wie einem Anschlußkasten oder einer Steckeraufnahme.

Es ist bekannt, an der Außenseite des Gehäuses eines Elektromotors einen Klemmenkasten zu befestigen, der durch Kabel, insbesondere Litzen oder durch eine Steckverbindung mit den elektrischen Anschlüssen des Motors verbunden ist. Ferner ist es bekannt, eine Leiterplatte für den Anschluß zwischen Klemmenkasten und Motor zu verwenden. Diese bekannten Verbindungsarten erfordern im Bereich der Anschlußstellen zwischen dem Motor und der Verbindung als auch zwischen der Verbindung und dem Klemmenkasten verhältnismäßig viel Platz, um zu gewahrleisten, daß die einzelnen Leiter ausreichend weit voneinander entfernt sind, so daß genügend große Kriech- und Luftstrecken zwischen den Leitern und Lötaugen verbleiben.

Aufgabe der Erfindung ist es, eine elektrische Verbindung der eingangs genannten Art so zu verbessern, daß bei ausreichend großen Kriech- und Luftstrecken zwischen den Anschlüssen sehr geringe Abmessungen der Gesamtanschlußstelle erreichbar sind.

Die Aufgabe wird erfindungsgmäß dadurch gelöst, daß sie eine Leiterfolie mit mehreren zueinander parallelen Leiterbahnen aufweist. Hierbei können im Bereich der Enden der Leiterbahnen die Folie eingeschlitzt und/oder eingestanzt sein, so daß die Folie zwischen den Schlitzen und/oder Stanzungen Zungen bildet, die jeweils den End- und Anschlußbereich einer Leiterbahn tragen. Dabei ist es von größtem Vorteil, wenn die Zungen aus der Ebene der Folie ausgebogen sind. Auch wird vorteilhafterweise vorgeschlagen, daß die Zungen in der Weise ausgebogen sind, daß jeweils zwei benachbarte Zungen in unterschiedlichen Ebenen enden.

Eine solche Konstruktion führt zu wesentlich kleineren Außenabmessungen bei ausreichend großen Abständen zwischen den einzelnen Anschlüssen. Damit können auch mehr Anschlüsse oder Schaltfunktionen pro Einbaufläche erreicht werden. Ferner werden automatische Fertigung und Montage erleichtert.

Wird die Erfindung am Beispiel eines Buchsenträger einer Umschaltsteckvorrichtung verwirklicht, so sind die Anschlüsse der Steckbuchsen in unterschiedlichen Ebenen ihrer Kunststoffträger angeordnet, so daß ihre rückseitigen steckbaren Lötanschlüsse ausreichende Kriech- und Luftstrecken gewährleisten. Sie lassen sich somit im Anschlußbereich bis auf die Wandstärken der jeweiligen Kammern, die zur Halterung und Führung der Steckbuchsen dienen, reduzieren. Die Flächenabmessungen des betreffenden Buchsenträgers können deutlich verkleinert werden, während die Höhenabmessungen des Umschaltsteckers aufgrund der unterschiedlichen Anschlußhöhe der Kontakte, nur geringfügig vergrößert werden müssen.

Besonders vorteilhaft ist es, wenn der Anschluß- oder Klemmenkasten ein Oberteil aufweist, das gegenüber dem Unterteil und/oder dem Motorengehäuse verschwenkbar ist und die Leiterfolie durch ihre Biegsamkeit die Schwenkbewegung mitmacht.

Ein Ausführungsbeispiel der Erfindung ist in den Zeichnungen dargestellt und wird im folgenden näher beschrieben.

Es zeigen

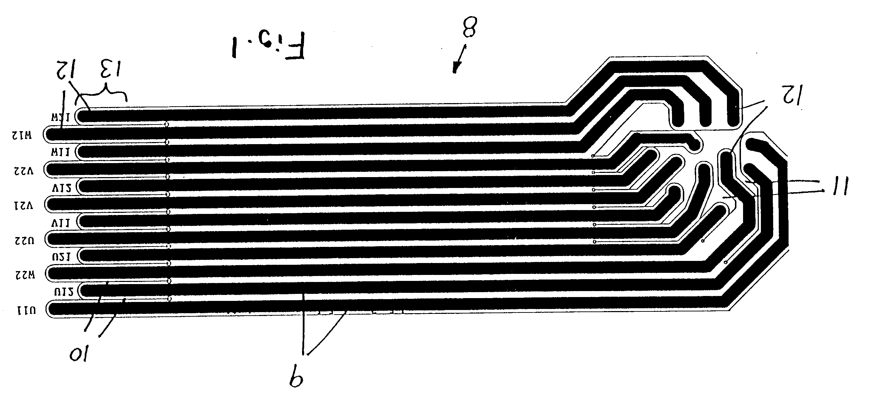

Figur 1    eine Draufsicht auf die Leiterfolie und

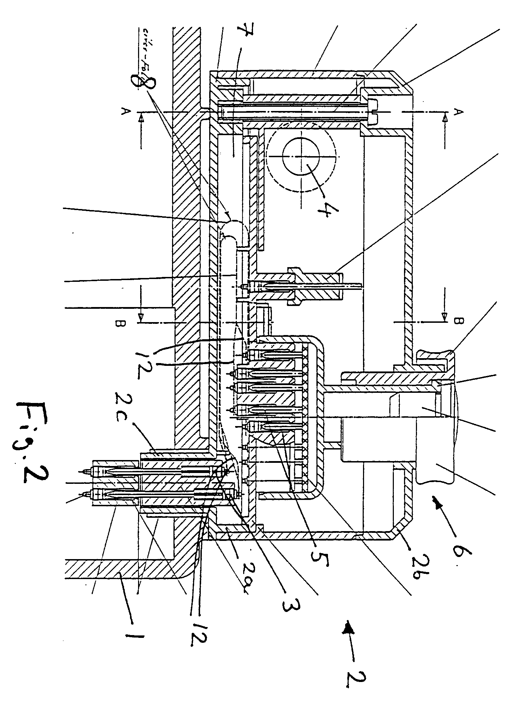

Figur 2    einen Schnitt durch einen am Motorengehäuse befestigten Klemmenkasten.

Auf dem Gehäuse 1 eines Elektromotors, insbesondere für Kreiselpumpen ist ein Klemmenkasten 2 befestigt, der aus einem Unterteil 2a und einem Oberteil 2b besteht. Das Unterteil 2a ragt mit einem Vorsprung 2c in eine Öffnung 1a des Gehäuses in den Elektromotor hinein, wobei dieser Vorsprung 2c hohl ausgebildet ist und in seinem Inneren Anschlüsse 3 trägt.

Am Unterteil 2a ist das Oberteil 2b um eine Achse 4 verschwenkbar angelenkt. An der Unterseite des Oberteils 2b sind Anschlüsse 5 gelagert, die unterhalb einer Steckeraufnahme 6 liegen und mit den Kontakten der Steckeraufnahme verbunden sind.

In dem flachen Raum 7 zwischen Unterteil 2a und Oberteil 2b liegt eine Leiterfolie 8 ein, deren Leiterbahnen 9 über den größten Teil ihrer Länge zueinander parallel sind. Im Bereich der Enden der Leiterbahnen ist die Folie eingeschnitten 10 oder eingestanzt 11, so daß durch diese Schnitte 10 und Stanzungen 11 die Folie Zungen 12 bildet, wobei jede Zunge mindestens ein Leiterbahnende 13 trägt.

Die Anschlüsse 3 und 5 liegen zueinander in unterschiedlichen Ebenen bzw. Höhen, wobei dafür gesorgt ist, daß benachbarte Anschlüsse unterschiedlich hoch angeordnet sind, so daß jeweils zwei benachbarte angeschlossene Zungen 12 in unterschiedlichen Ebenen enden.

Durch dieses abwechselnde Ausbiegen der Zungen 12 in unterschiedliche Ebenen werden die Abstände der Leiterbahnenden 13, insbesondere im Bereich der Anschlußstellen (Lötstellen) größer.

Durch ein aufklappendes Verschwenken des Oberteils 2b gegenüber dem Unterteil 2a werden die Anschlußstellen an beiden Seiten der Leiterfolie sehr gut zugänglich, so daß Montage und insbesondere das Anlöten der Leiterbahnenden erleichtert wird.

**Patentansprüche**

1. Elektrische Verbindung zwischen einem Elektromotor (1) und einem Anschlußteil wie einem Anschlußkasten (2) oder einer Steckeraufnahme, **dadurch gekennzeichnet,** daß sie eine Leiterfolie (8) mit mehreren zueinander parallelen Leiterbahnen (9) aufweist.

2. Elektrische Verbindung nach Anspruch 1, **dadurch gekennzeichnet,** daß im Bereich der Enden (13) der Leiterbahnen (9) die Folie eingeschlitzt (10) und/oder eingestanzt (11) ist, so daß die Folie zwischen den Schlitzen (10) und/oder Stanzungen (11) Zungen (12) bildet, die jeweils den End- und Anschlußbereich einer Leiterbahn (9) tragen.

3. Elektrische Verbindung nach Anspruch 2, **dadurch gekennzeichnet,** daß die Zungen (12) aus der Ebene der Folie (8) ausgebogen sind.

4. Elektrische Verbindung nach Anspruch 2 oder 3, **dadurch gekennzeichnet,** daß die Zungen (12) in der Weise ausgebogen sind, daß jeweils zwei benachbarte Zungen (12) in unterschiedlichen Ebenen enden.

5. Elektrische Verbindung nach einem der vorherigen Ansprüche, **dadurch gekennzeichnet,** daß der Anschluß- oder Klemmenkasten (2) ein Oberteil (2b) aufweist, das gegenüber dem Unterteil (2a) und/oder dem Motorengehäuse (1) verschwenkbar ist und die Leiterfolie (8) durch ihre Biegsamkeit die Schwenkbewegung mitmacht.

Fig.1

EP 0 511 474 A1

Fig.2

**Europäisches Patentamt**

**EUROPÄISCHER RECHERCHENBERICHT**

Nummer der Anmeldung

EP  92 10 3856

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| X | US-A-3 476 903 (LOFSTRAND) <br> * Spalte 1, Zeile 61 - Spalte 2, Zeile 20 * <br> * Spalte 2, Zeile 44 - Spalte 3, Zeile 5; <br> Abbildungen 1,3,4 * | 1,2,5 | H02K5/22 <br> H01R23/66 |
| Y | --- | 3,4 | |
| Y | US-A-3 325 769 (TRAVIS) <br> * Spalte 3, Zeile 31 - Zeile 42; Abbildung 9 * <br> --- | 3,4 | |
| X | DE-A-1 515 504 (BRAUN) <br> * Seite 4, Zeile 3 - Seite 5, Zeile 10; <br> Abbildungen 1-3 * <br> --- | 1-4 | |
| X | US-A-4 923 406 (BUCKNAM) <br> * Spalte 3, Zeile 15 - Spalte 5, Zeile 8; <br> Abbildungen 1-5 * | 1 | |
| Y | --- | 5 | |
| Y | EP-A-0 411 239 (INTERCONNECTRON) <br> * Spalte 4, Zeile 4 - Spalte 6, Zeile 13; <br> Abbildungen 1-8 * <br><br> ----- | 5 | |

**RECHERCHIERTE SACHGEBIETE (Int. Cl.5 )**

H02K
H01R

Der vorliegende Recherchenbericht wurde für alle Patentansprüche erstellt

| Recherchenort | Abschlußdatum der Recherche | Prüfer |
|---|---|---|
| DEN HAAG | 17 JUNI 1992 | TIO K.H. |